# EUROPÄISCHE PATENTSCHRIFT

(11) **EP 2 229 424 B1**
(45) Veröffentlichungstag und Bekanntmachung des Hinweises auf die Patenterteilung: **21.10.2015**
(21) Anmeldenummer: 08876948.4
(22) Anmeldetag: 29.10.2008
(51) Int. Cl.: C09K 11/02, C09K 11/80, C09K 11/59, H01L 33/50

(54) **OBERFLÄCHENMODIFIZIERTE KONVERSIONSLEUCHTSTOFFE**
SURFACE-MODIFIED CONVERSION LUMINOUS SUBSTANCES
SUBSTANCES LUMINESCENTES DE CONVERSION À SURFACE MODIFIÉE

(30) Priorität: 22.11.2007 DE 102007056342
(43) Veröffentlichungstag der Anmeldung: 22.09.2010
(73) Patentinhaber: Merck Patent GmbH, 64293 Darmstadt (DE)
(72) Erfinder: PETRY, Ralf, 64347 Griesheim (DE); RUEGER, Reinhold, 63322 Roedermark (DE); VOSGROENE, Tim, 64372 Ober-Ramstadt (DE); WINKLER, Holger, 64291 Darmstadt (DE)
(86) Internationale Anmeldenummer: PCT/EP2008/009142
(87) Internationale Veröffentlichungsnummer: WO 2010/060437

(56) Entgegenhaltungen:
- JP-A- 9 279 137
- JP-A- 2005 330 490
- US-A- 4 921 727
- US-A1- 2002 105 266
- US-A1- 2003 098 644
- US-A1- 2004 135 121
- US-B1- 6 177 030
- SCHLOTTER P ET AL: "Fabrication and characterization of GaN/InGaN/AlGaN double heterostructure LEDs and their application in luminescence conversion LEDs" MATERIALS SCIENCE AND ENGINEERING B, ELSEVIER SEQUOIA, LAUSANNE, CH LNKD- DOI:10.1016/S0921-5107(98)00352-3, Bd. 59, Nr. 1-3, 6. Mai 1999 (1999-05-06), Seiten 390-394, XP004173273 ISSN: 0921-5107

## Beschreibung

Die Erfindung betrifft oberflächenmodifizierte Leuchtstoffpartikel, auf die eine Metall-, Übergangsmetall- oder Halbmetalloxidbeschichtung und anschließend eine organische Beschichtung aufgebracht ist sowie deren Herstellverfahren.

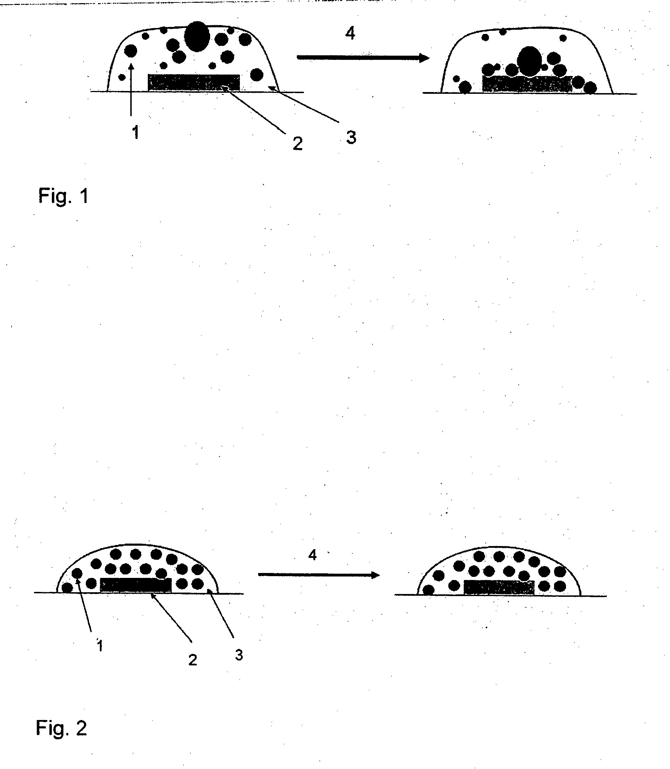

Während der Aushärtung des Harzes, welches die LED Leuchtstoffe enthält, kommt es zu einer Sedimentation der Leuchtstoffpartikel. Als Folge entsteht eine inhomogene und nicht reproduzierbare Verteilung der Leuchtstoffe über dem LED Chip bzw. in der Remote-Phosphor-Schicht. Als Resultat weisen die LEDs große Unterschiede in der Lichtverteilung auf; sowohl die Verteilung über einer LED ist stark wirtkelabhängig (Abbildung 1), als auch die Lichteigenschaften von LED zu LED innerhalb einer Charge ist nicht einheitlich. Dadurch ist der LED Hersteller gezwungen, ein aufwändiges und kostenintensives Binning durchzuführen, welches in geringen Ausbeuten an verkaufsfähigen LEDs resultiert (Der Ziel-Bin mit Lichteigenschaften, welche die Anforderungen erfüllen hat eine Ausbeute von in etwa bis zu 10% der gesamten Produktion. Die restlichen weißen LEDs werden entweder vernichtet, oder als "open Bin" oft unter Zweitmarken für anspruchslose Anwendungen zu niedrigen Preisen verkauft). Dieser Aufwand wird deutlich aus den Preisunterschieden zwischen blauen LEDs und weißen Leuchtstoff enthaltenden LEDs, welcher bis zu 100% betragen kann. Die hohen Initialkosten der weißen LEDs wiederum behindern die schnelle Substitution von uneffizienten und mit kurzer Lebensdauer behafteten Glühbirnen, Halogenlampen und Fluoreszenzlampen durch weiße LEDs.

Eine Funktionalisierung von Leuchtstoffen ist in der Literatur bereits beschrieben. In A. Meijerink et al. ,Phys. Chem. Chem. Phys., 2004, 6, 1633 - 1636 wird beschrieben, wie man Nanoleuchtstoffe, welche über eine reaktive Oberfläche verfügen (intrinsische Eigenschaft von Nanopartikeln, die ein großes Oberfläche zu Volumen-Verhältnis aufweisen und die hohe Obertlächenenergie mit Bindungen jeglicher Art absättigen) mit Glyzin als Linker an Tetramethylrhodamin (Farbstoff) anbindet, um einen Ladungstransfer zu beobachten. Das beschriebene Verfahren ist jedoch ungeeignet um Leuchtstoffe an Harze anzubinden bzw. eine Kompatibilisiereung zu erreichen.
Aus Y. T. Nien et al. Materials Chemistry and Physics, 2005, 93, 79 - 83 ist bekannt, wie man Nanoleuchtstoffe in HMDS (Hexamethyldisilazan) einbettet, um die reaktive und instabile Oberfläche abzusättigen. In diesem Fall findet keine Anbindung, sondern lediglich ein Einbetten des Nanoleuchtstoffes in eine SiO₂-Matrix statt.

Aus der US 2007/0092758 ist eine Leuchtstoffpaste bekannt, die aus einen Leuchtstoff, einem Silan-haltigen Dispergiermittel sowie einem organischen Harz besteht. Es werden Leuchtstoff, Dispergiermittel und Bindemittel gemischt und der Leuchtstoff in das Bindemittel eindispergiert. Die verwendeten Dispergiermittel bestehen aus einem speziellen hydrophoben organischen Rest, einer hydrophoben Gruppe und einer an die hydrophile Gruppe gebundenen Silanol-Ankergruppe. Für die homogene Verteilung des Leuchtstoffes ist es trotz der zugesetzten Dispergiermittel notwendig, die Paste einer Mahlung zu unterwerfen. Dabei kann es zu einer Verschlechterung der Eigenschaften des Leuchtstoffes kommen, z.B. durch den hohen Energieeintrag oder durch Kontaminationen aus dem Mahlkörpermaterial.

Die Aufgabe der vorliegenden Erfindung bestand nun einerseits darin, die oben genannten Nachteile wie inhomogene und nicht reproduzierbare Verteilung der Leuchtstoffpartikel über dem LED Chip zu vermeiden und andererseits einen Leuchtstoff bereitzustellen, der sich einfach in verschiedene Bindesysteme einarbeiten lässt.

Überraschenderweise wurde jetzt gefunden, dass diese Inhomogenität der Lichtverteilung, welche durch inhomogene Leuchtstoffschichten verursacht wird, durch eine Kompatibilisierung der Leuchtstoffoberfläche mit dem Silikon- oder Epoxidharz vermieden wird. Bei der Kompatibilisierung wird die Oberfläche des Leuchtstoffes mit funktionellen chemischen Gruppen und Linkern ausgestattet. Diese erlauben eine Anpassung der Leuchtstoffpartikel an die hydrophilen oder hydrophoben Eigenschaften des Harzes. Dadurch lassen sich homogene Mischungen aus Harz und Leuchtstoff herstellen, welche nicht zur Ausflockung neigen.

Aus US 2004/135121 A1 sind SrAl₂O₄:Eu-Partikel bekannt, die mit SiO₂ und einem Organosilan beschichtet sind.

Aus US 2002/105266 A1 sind beschichtete Leuchtstoffpartikel bekannt, wobei die Beschichtung ausgewählt ist aus der Gruppe umfassend organische Materialien, anorganische Materialien und glasartige Materialien. Es sind jedoch keine Phosphore offenbart, die sowohl mit einem anorganischen wie auch mit einem organischen Material beschichtet sind.

Gegenstand der vorliegenden Erfindung sind somit oberflächenmodifizierte Leuchtstoffpartikel auf der Basis von lumineszierenden Teilchen, die mindestens eine lumineszierende Verbindung ausgewählt aus der Gruppe der (Y, Gd, Lu, Sc, Sm, Tb)₃ (Al, Ga)₅O₁₂:Ce (mit oder ohne Pr), YSiO₂N:Ce, Y₂Si₃O₃N₄:Ce, Gd₂Si₃O₃N₄:Ce, BaMgAl₁₀O₁₇:Eu (mit oder ohne Mn), SrAl₂O₄:Eu, (Ca,Sr,Ba)Si₂N₂O₂:Eu, SrSiAl₂O₃N₂:Eu, (Ca,Sr,Ba)₂Si₅N₈:Eu, (Ca,Sr,Ba)SiN₂:Eu, CaAlSiN₃:Eu, Molybdate, Wolframate, Vanadate, jeweils einzeln oder Gemischen derselben mit einem oder mehreren Aktivatorionen wie Ce, Eu, Mn, Cr, Tb und/oder Bi, enthalten, wobei (Ca,Sr,Ba)₂SiO₄ und andere Silikate mit einem oder mehreren Aktivatorionen wie Eu, Ce und Mn und/oder Codotanten basierend auf Fe, Cu und/oder Zn ausgenommen sind, und wobei auf die lumineszierenden Teilchen mindestens eine anorganische Schicht, enthaltend Oxide oder Hydroxide von Si, Al, Zr, Zn, Ti und/oder Mischungen hieraus, sowie anschließend eine organische Beschichtung aus Organosilanen oder Polyorganosiloxanen (Silicone) und/oder Mischungen hieraus, aufgebracht ist.

Die funktionellen Gruppen an der Oberfläche des Leuchtstoffes bilden eine Verschlaufung und/oder Vernetzung bzw. chemische Verbindung mit den Komponenten des Harzes. Auf diese Weise lässt sich eine homogene Verteilung der Leuchtstoffpartikel im Harz fixieren. Während des Harzaushärtungsprozesses findet keine Sedimentation der Leuchtstoffpartikel statt. Insbesondere bei nasschemisch hergestellten, über eine hohe Homogenität der Partikeleigenschaften (z.B. Morphologie, Partikelgrößenverteilung) verfügenden Leuchtstoffen lassen sich erfindungsgemäß vorteilhafte Leuchtstoffschichten realisieren.

Die Lichteigenschaften einer weißen LED, welche mit den erfindungsgemäß beschichteten Leuchtstoffen versehen sind, können der Figur 1 (schwarze Kurve) entnommen werden: die CCT ist über den gesamten Winkelbereich über der LED homogen; d.h. der Beobachter nimmt in jeder Position die gleiche Farbtemperatur ("Lichtfarbe") wahr. Im Gegensatz hierzu zeigt die mit herkömmlichen (über mix & fire hergestellt) Leuchtstoffen versehene, weiße LED eine große Varianz der CCT, so dass der Beobachter in verschiedenen Richtungen eine andere Lichtfarbe wahrnimmt.

Bei der Funktionalisierung bzw. Oberflächenmodifizierung werden zuerst reaktive Hydroxygruppen auf der Oberfläche der Leuchtstoffpartikel durch ein Metall-, Übergangsmetall- oder Halbmetalloxid über nasschemische oder Aufdampfprozesse (CVD-Verfahren) gebildet.

Die anorganische Beschichtung enthält vorzugsweise Nanopartikel und/oder Schichten aus Oxiden/Hydroxiden des Si, Al, Zr, Zn, Ti und/oder Mischungen hieraus. Besonders bevorzugt ist eine Siliciumoxid/-hydroxid-Beschichtung, da sie über besonders viele reaktive Hydroxygruppen verfügt, wodurch eine weitere Anlagerung einer organischen Beschichtung erleichtert wird.

Die anorganische Beschichtung aus Oxiden/Hydroxiden von Al, Zr, Zn, Ti und/oder Mischungen hieraus, ist vorzugsweise weitgehend transparent, d.h. sie muss sowohl für das Anregungs- wie auch für das Emissionsspektrum der jeweils eingesetzten Konversionsleuchtstoffe eine 90 %ige bis 100 %ige Transparenz gewährleisten. Andererseits kann die Transparenz der erfindungsgemäßen Beschichtung für alle Wellenlängen, die nicht den Anregungs- und Emissionswellenlängen entsprechen auch weniger als 90 % bis 100 % betragen.
Die beschichteten Leuchtstoffpartikel werden dann mit einer organischen, vorzugsweise weitgehend transparenten Beschichtung, aus Organosilanen oder Polyorganosiloxanen (Silicone) und/oder Mischungen hieraus, versehen. Diese Beschichtung erfolgt auch nasschemisch oder durch einen Aufdampfprozess. Die Silizium-organischen Verbindungen reagieren dabei mit den Oberflächen-OH-Gruppen der Leuchtstoffpartikel bzw. mit der anorganischen Beschichtung. Die Ketten der organischen Siliziumverbindung bilden eine mehr oder weniger poröse Schicht um die Leuchtstoffpartikel. Durch Modifizierung der organischen Ketten der Siliziumverbindungen wird die gewünschte Hydrophobie der Leuchtstoffpartikel, Struktur der Oligomer/Polymerketten und die Ankopplung (physikalische und/oder chemisch) an das Harz gesteuert. Als Organosilane werden bevorzugt Alkoxysilane eingesetzt. Beispiele für Organosilane sind Propyltrimethoxysilan, Propyltriethoxysilan, Isobutyltrimethoxysilan, n-Octyltrimethoxysilan, i-Octyltrimethoxysilan, n-Octyltriethoxysilan, n-Decyltrimethoxysilan, Dodecyltrimethoxysilan, Hexadecyltrimethoxysilan, Vinyltrimethoxysilan, vorzugsweise n-Octyltrimethoxysilan und n-Octyltriethoxysilan. Als oligomere, alkoholfreie Organosilanhydrolysate eignen sich unter anderem die unter dem Handelsnamen "Dynasylan^{®}" von der Fa. Sivento vertriebenen Produkte, wie z. B. Dynasylan HS 2926, Dynasylan HS 2909, Dynasylan HS2907, Dynasylan HS 2781, Dynasylan HS 2776, Dynasylan HS 2627. Darüber hinaus eignet sich oligomeres Vinylsilan als auch Aminosilanhydrolysat als organische Beschichtung. Funktionalisierte Organosilane sind beispielsweise 3-Aminopropyltrimethoxysilan, 3-Methacryloxytrimethoxysilan, 3-Glycidyloxypropyltrimethoxysilan, beta-(3,4-Epoxycyclohexyl)-ethyltrimethoxysilan, gamma-Isocyanatopropyltrimethoxysilan, 1,3-bis(3-glycidoxypropyl)-1,1,3,3,-tetramethyldisliloxan, Ureidopropyltriethoxysilan, bevorzugt sind 3-Aminopropyltrimethoxysilan, 3-Methacryloxytrimethoxysilan, 3-Glycidyloxypropyltrimethoxysilan, beta-(3,4-Epoxycyclohexyl)-ethyltrimethoxysilan, gamma-Isocyanatopropyltrimethoxysilan.
Besonders bevorzugt werden folgende Verbindungen alleine oder in Mischungen eingesetzt:
- Silquest A-186^{®} [beta-(3,4-Epoxycyclohexyl)ethyltrimethoxysilan]
- Silquest A-1310^{®} gamma-Isocyanatopropyltriethoxysilan
- Silquest A-1110^{®} gamma-Aminopropyltrimethoxysilan
- Silquest A-1524^{®} gamma-Harnstoffpropyltrimethoxysilan
- Silquest A- 174⁹ gamma-Methacryloxypropyltrimethoxysilan
- Silquest A-151^{®} Vinyltriethoxysilan

Beispiele für polymere Silansysteme bzw. Polyorganosiloxane sind in WO 98/13426 beschrieben und werden z. B. von der Fa. Sivento unter dem Warenzeichen Hydrosil^{®} vertrieben.

Die Wahl eines geeigneten Silans ist u.a. davon abhängig, ob die Anbindung des Silans an einen Epoxidharz oder an einen Siliconharz erfolgen soll. Für Hochleistungs-LEDs (Highpower-LEDs mit elektrischer Anschlussleistung von min. 1 W) wird man einen Langzeitstrahlungs- und temperaturstabilen Siliconharz verwenden, für low- oder medium-power-LEDs (elektrische Anschlussleistung < 1W) hingegen, wie sie z.B. für Backlighting-Anwendungen geeignet sind, wird man einen weniger temperatur- und strahlungsstabilen Epoxidharz auswählen.

Die Partikelgröße der erfindungsgemäßen Leuchtstoffe beträgt zwischen 1 µm und 40 µm, vorzugsweise zwischen 2 µm und 20 µm.

Die Dicke der erfindungsgemäßen Beschichtung, bestehend aus anorganischer und organischer Beschichtung, beträgt zwischen 5 nm und 200 nm, vorzugsweise 10 nm und 50 nm. Die Teilchengröße der Primärpartikel der Metall-, Übergangsmetall- oder Halbmetalloxid-Beschichtung beträgt zwischen 5 nm und 50 nm. Die erfindungsgemäße Beschichtung ist nicht zwangsläufig homogen, sondern kann auch in Form von Inseln oder in Tropfenform auf der Oberfläche der Partikel vorliegen. Die Dicke der organischen Beschichtung hängt ab von der Molmasse der organischen Gruppen und kann zwischen 0.5 nm und 50 nm, vorzugsweise zwischen 1 und 5 nm liegen.
Die Menge der organischen Beschichtung beträgt zwischen 0.02 und 5 Gew.% bezogen auf den oberflächenbeschichteten Leuchtstoffpartikel, vorzugsweise 0.1 bis 2 Gew.%.

Ein weiterer Gegenstand der vorliegenden Erfindung ist ein Verfahren zur Herstellung eines oberflächenmodifizierten Leuchtstoffpartikel gekennzeichnet durch die Schritte:
a. Herstellen eines Leuchtstoffpartikels ausgewählt aus den oben beschriebenen Leuchtstoffgruppen durch Mischen von mindestens zwei Edukten und mindestens einem Dotierstoff und thermische Behandlung bei einer Temperatur T > 150 °C,
b. der Leuchtstoffpartikel wird in einem nasschemischen oder Aufdampfprozess mit einer anorganischen Schicht enthaltend Oxide/Hydroxide von Al, Zr, Zn, Ti und/oder Mischungen hieraus, beschichtet,
c. Aufbringung einer organischen Beschichtung aus Organosilanen oder Polyorganosiloxaneh (Silicone) und/oder Mischungen hieraus.

Die Beschichtung der Leuchtstoffpartikel erfolgt besonders bevorzugt nasschemisch durch Auffällen der oben genannten Oxide oder Hydroxide in wässriger Dispersion. Dazu wird der unbeschichtete Leuchtstoff in einem Reaktor in Wasser suspendiert und durch gleichzeitiges Zudosieren mindestens eines Metallsalzes und mindestens eines Fällungsmittels unter Rühren mit dem Metalloxid oder Hydroxid beschichtet.
Alternativ zu Metallsalzen können auch metallorganische Verbindungen, z.B. Metallalkoholate, zudosiert werden, die dann durch hydrolytische Zersetzung Metalloxide oder-hydroxide bilden. Ein anderer möglicher Weg zur Beschichtung der Partikel ist die Beschichtung über einen Sol-Gel-Prozess in einem organischen Lösungsmittel wie beispielsweise Ethanol oder Methanol. Dieses Verfahren eignet sich besonders für wasserempfindliche Materialien sowie für säure- oder alkaliempfindliche Stoffe.

Die Edukte zur Herstellung des Leuchtstoffs bestehen, wie oben erwähnt, aus dem Basismaterial (z. B. Salzlösungen des Aluminiums, Yttriums und Cer) sowie mindestens einem Dotierstoff, vorzugsweise Europium oder Cer und gegebenenfalls weiteren Gd-, Lu-, Sc-, Sm-, Tb-, Pr- und/oder Gahaltigen Materialien. Als Edukte kommen anorganische und/oder organische Stoffe wie Nitrate, Carbonate, Hydrogencarbonate, Phosphate, Carboxylate, Alkoholate, Acetate, Oxalate, Halogenide, Sulfate, metallorganische Verbindungen, Hydroxide und/oder Oxide der Metalle, Halbmetalle, Übergangsmetalle und/oder Seltenerden in Frage, welche in anorganischen und/oder organischen Flüssigkeiten gelöst und/oder suspendiert sind. Vorzugsweise werden Mischnitratlösungen, Chlorid- oder Hydroxidlösungen eingesetzt, welche die entsprechenden Elemente im erforderlichen stöchiometrischen Verhältnis enthalten.

Die nasschemische Herstellung besitzt gegenüber der herkömmlichen Festkörperdiffusions-Methode (engl. mixing and firing) generell den Vorteil, dass die resultierenden Materialien eine höhere Einheitlichkeit in Bezug auf die stöchiometrische Zusammensetzung, die Partikelgröße und die Morphologie der Partikel aufweisen, aus denen der erfindungsgemäße Leuchtstoff hergestellt wird.

Für die nasschemische Herstellung eines Leuchtstoffpartikels bestehend z.B. aus einem Gemisch von Yttriumnitrat-, Aluminiumnitrat- und Cernitratlösung sind folgende bekannte Methoden bevorzugt:
- Cofällung mit einer NH₄HCO₃-Lösung (*siehe z.B.* Jander, Blasius Lehrbuch der analyt. u. präp. anorg. Chem. 2002*)*
- Pecchini-Verfahren mit einer Lösung aus Zitronensäure und Ethylenglykol *(siehe z.B.* Annual Review of Materials Research Vol. 36: 2006, 281-331*)*
- Combustion-Verfahren unter Verwendung von Harnstoff
- Sprühtrocknung wässriger oder organischer Salzlösungen (Edukte)
- Sprühpyrolyse (auch Spraypyrolyse genannt) wässriger oder organischer Salzlösungen (Edukte)

Bei der o.g. erfindungsgemäß besonders bevorzugten Cofällung werden z.B. Chlorid- oder Nitratlösungen der entsprechenden Leuchtstoffedukte mit einer NH₄HCO₃-Lösung versetzt, wodurch sich der Leuchtstoffprecursor bildet.

Beim Pecchini-Verfahren werden z.B. die o.g. Nitratlösungen der entsprechenden Leuchtstoffedukte bei Raumtemperatur mit einem Fällungsreagenz bestehend aus Zitronensäure und Ethylenglykol versetzt und änschließend erhitzt. Durch Erhöhung der Viskosität kommt es zur Leuchtstoffprecursor-Bildung.

Beim bekannten Combustion-Verfahren werden z.B. die o.g. Nitratlösungen der entsprechenden Leuchtstoffedukte in Wasser gelöst, dann unter Rückfluss gekocht und mit Harnstoff versetzt, wodurch sich der Leuchtstoffprecursor langsam bildet.

Die Sprühpyrolyse gehört zu den Aerosolverfahren, die durch Versprühen von Lösungen, Suspensionen oder Dispersionen in einen durch unterschiedliche Art und Weise erhitzten Reaktionsraum (Reaktor) sowie die Bildung und Abscheidung von Feststoff- Partikeln gekennzeichnet sind. Im Gegensatz zur Sprühtrocknung mit Heißgastemperaturen < 200°C finden bei der Sprühpyrolyse als Hochtemperatur- Prozess außer der Verdampfung des Lösungsmittels zusätzlich die thermische Zersetzung der verwendeten Edukte (z. B. Salze) sowie die Neubildung von Stoffen (z. B. Oxide, Mischoxide) statt.

Die o.g. 5 Verfahrensvarianten sind ausführlich in der DE 102006027133.5 (Merck) beschrieben, die voll umfänglich in den Kontext der vorliegenden Anmeldung durch Bezugnahme eingefügt wird.

Die Herstellung der erfindungsgemäßen oberflächenmodifizierten Leuchtstoffpartikel kann nach verschiedenen nasschemischen Methoden erfolgen, indem
1) eine homogene Ausfällung der Bestandteile erfolgt, gefolgt von der Abtrennung des Lösemittels und einer ein- oder mehrstufigen thermischen Nachbehandlung, wobei ein Schritt davon in reduzierender Atmosphäre erfolgen kann,
2) die Mischung fein verteilt wird, beispielsweise mit Hilfe eines Sprühprozesses und eine Entfernung des Lösemittels erfolgt, gefolgt von einer ein -oder mehrstufigen thermischen Nachbehandlung, wobei ein Schritt davon in reduzierender Atmosphäre erfolgen kann, oder
3) die Mischung fein verteilt wird, beispielsweise mit Hilfe eines Sprühprozesses und eine Entfernung des Lösemittels einhergehend mit einer Pyrolyse erfolgt, gefolgt von einer ein- oder mehrstufigen thermischen Nachbehandlung, wobei ein Schritt davon in reduzierender Atmosphäre erfolgen kann.
4) die mit Hilfe der Methoden 1 - 3 hergestellten Leuchtstoffe nachträglich nasschemisch beschichtet werden.

Vorzugsweise geschieht die nasschemische Herstellung des Leuchtstoffes nach dem Präzipitations- und/oder Sol-Gel-Verfahren.

Bei der oben genannten thermischen Nachbehandlung ist es bevorzugt, wenn die Glühung zumindest teilweise unter reduzierenden Bedingungen (z.B. mit Kohlenmonoxid, Formiergas, reinem Wasserstoff, Mischungen aus Wasserstoff mit einem Inertgas oder zumindest Vakuum oder Sauerstoffmangel-Atmosphäre) durchgeführt wird.

Generell ist es auch möglich, die erfindungsgemäßen unbeschichteten Leuchtstoffe über die Festkörperdiffusions-Methode herzustellen, was jedoch die schon erwähnten Nachteile verursacht.

In einer weiteren Ausführungsform kann es erfindungsgemäß auch von Vorteil sein, wenn man die Beschichtung mit einem anorganischem Oxid weglässt und die Leuchtstoffpartikel nur mit einer organischen Beschichtung versieht.

Mit Hilfe der oben genannten Verfahren können beliebige äußere Formen der Leuchtstoffpartikel hergestellt werden, wie sphärische Partikel, Plättchen und strukturierte Materialien und Keramiken.

Die Anregbarkeit der erfindungsgemäßen Leuchtstoffe erstreckt sich zudem über einen weiten Bereich, der von etwa 250 nm bis 560 nm, bevorzugt 380 nm bis zu etwa 500 nm reicht. Damit sind diese Leuchtstoffe zur Anregung durch UV oder blau emittierende Primärlichtquellen wie LEDs oder konventionellen Entladungslampen (z.B. auf Hg-Basis) geeignet.

Ein weiterer Gegenstand der vorliegenden Erfindung ist eine. Beleuchtungseinheit mit mindestens einer Primärlichtquelle, dessen Emissionsmaximum im Bereich 250 nm bis 530 nm, bevorzugt 380 nm bis zu etwa 500 nm reicht, wobei die primäre Strahlung teilweise oder vollständig durch die erfindungsgemäßen oberflächenmodifizierten Leuchtstoffe in längerwellige Strahlung konvertiert wird. Vorzugsweise ist diese Beleuchtungseinheit weiß emittierend oder emittiert Licht mit einem bestimmten Farbpunkt (Color-on-demand-Prinzip).

In einer bevorzugten Ausführungsform der erfindungsgemäßen Beleuchtungseinheit handelt es sich bei der Lichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 ist.
Dem Fachmann sind mögliche Formen von derartigen Lichtquellen bekannt. Es kann sich hierbei um lichtemittierende LED-Chips unterschiedlichen Aufbaus handeln.

In einer weiteren bevorzugten Ausführungsform der erfindungsgemäßen Beleuchtungseinheit handelt es sich bei der Lichtquelle um eine lumineszente auf ZnO, TCO (Transparent conducting oxide), ZnSe oder SiC basierende Anordnung oder auch um eine auf einer organischen lichtemittierende Schicht basierende Anordnung (OLED).

In einer weiteren bevorzugten Ausführungsform der erfindungsgemäßen Beleuchtungseinheit handelt es sich bei der Lichtquelle um eine Quelle, die Elektrolumineszenz und/oder Photolumineszenz zeigt. Weiterhin kann es sich bei der Lichtquelle auch um eine Plasma- oder Entladungsquelle handeln.

Die erfindungsgemäßen Leuchtstoffe können entweder in einem Harz dispergiert (z.B. Epoxid- oder Siliconharz), direkt auf der Primärlichtquelle angeordnet werden oder aber von dieser, je nach Anwendung, entfernt angeordnet sein (letztere Anordnung schliesst auch die "Remote phosphor Technologie" mit ein). Die Vorteile der "Remote phosphor Technologie" sind dem Fachmann bekannt und z.B. der folgenden Publikation zu entnehmen: Japanese Journ. of Appl. Phys. Vol. 44, No. 21 (2005). L649-L651.

In einer weiteren Ausführungsform ist es bevorzugt, wenn die optische Ankopplung der Beleuchtungseinheit zwischen dem beschichteten Leuchtstoff und der Primärlichtquelle durch eine lichtleitende Anordnung realisiert wird.
Dadurch ist es möglich, dass an einem zentralen Ort die Primärlichtquelle installiert wird und diese mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem Lichtleiter, der an die Primärlichtquelle angekoppelt ist, realisieren. Auf diese Weise ist es möglich, eine starke Primärlichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Ein weiterer Gegenstand der vorliegenden Erfindung ist die Verwendung der erfindungsgemäßen Leuchtstoffe zur teilweisen oder vollständigen Konversion der blauen oder im nahen UV-liegenden Emission einer Lumineszenzdiode.

Ein weiterer Gegenstand der vorliegenden Erfindung ist die Verwendung der erfindungsgemäßen Leuchtstoffe in Elektrolumineszenz-Materialien, wie beispielsweise Elektrolumineszenz-Folien (auch Leuchtfolien oder Lichtfolien genannt), in denen beispielsweise Zinksulfid oder Zinksulfid dotiert mit Mn²⁺, Cu⁺, oder Ag⁺ als Emitter eingesetzt wird, die im gelbgrünen Bereich emittieren. Die Anwendungsbereiche der Elektrolumineszenz-Folie sind z.B. Werbung, Displayhintergrundbeleuchtung in Flüssigkristallbildschirmen (LC-Displays) und Dünnschichttransistor-Displays (TFT-Displays), selbstleuchtende KFZ-Kennzeichenschilder, Bodengrafik (in Verbindung mit einem tritt- und rutschfesten Laminat), in Anzeigen- und/oder Bedienelementen beispielsweise in Automobilen, Zügen, Schiffen und Flugzeugen oder auch Haushalts-, Garten-, Mess- oder Sport- und Freizeitgeräten.

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

### Beispiele

### Ausführungsbeispiel 1: Beschichtung eines YAG:Ce-Leuchtstoffpulvers mit SiO₂ (Erzeugung aktiver Hydroxygruppen)

50 g eines YAG:Ce-Leuchtstoffes werden in einem 2-L-Reaktor mit Schliffdeckel, Heizmantel und Rückflußkühler in 1 Liter Ethanol suspendiert. Dazu wird eine Lösung von 17 g Ammoniakwasser (25 Gew% NH₃) in 170 g Wasser gegeben. Unter Rühren wird bei 65 °C eine Lösung von 48 g Tetraethylorthosilikat (TEOS) in 48 g wasserfreiem Ethanol langsam (ca. 1 ml/min) zugetropft. Nach Beendigung der Zugabe wird die Suspension nach 2 Stunden nachgerührt, auf Raumtemperatur gebracht und abfiltriert. Der Rückstand wird mit Ethanol gewaschen und getrocknet.

### Ausführungsbeispiel 2: Beschichtung eines YAG:Ce-Leuchtstoffes mit Al₂O₃

In einem Glasreaktor mit Heizmantel werden 50 g YAG:Ce-Leuchtstoff in 950 g VE-Wasser suspendiert. Zu der Suspension werden unter Rühren bei 80 °C 600g einer wässrigen Lösung von 98,7 g AlCl₃ *6H₂O pro Kg Lösung enthält, in 2 ½ Stunden zudosiert. Dabei wird der pH-Wert durch Zudosierung von Natronlauge konstant auf 6,5 gehalten. Nach dem Ende der Zudosierung wird noch 1 Stunde bei 80°C nachgerührt, dann wird auf Raumtemperatur abgekühlt, der Leuchtstoff abfiltriert, mit Wasser gewaschen und getrocknet.

### Ausführungsbeispiel 3: Beschichtung eines Nitrid- Leuchtstoffpulvers mit Si02

50 g Sr_{0,5}Ba_{0,5}SiN₂:Eu werden in einem 2-L-Reaktor mit Schliffdeckel, Heizmantel und Rückflußkühler in 1 Liter Ethanol suspendiert. Dazu wird eine Lösung von 17 g Ammoniakwasser (25 Gew% NH₃) in 170 g Wasser gegeben. Unter Rühren wird bei 65 °C eine Lösung von 35 g Tetraethylorthosilikat (TEOS) in 35 g wasserfreiem Ethanol langsam (ca. 1 ml/min) zugetropft. Nach Beendigung der Zugabe wird die Suspension nach 2 Stunden nachgerührt, auf Raumtemperatur gebracht und abfiltriert. Der Rückstand wird mit Ethanol gewaschen und getrocknet.

### Ausführunasbeispiel 4: Beschichtung eines Nitrid- Leuchtstoffpulvers mit Al₂O₃

In einem Glasreaktor mit Heizmantel werden 50 g (Ca_{0,5}Sr_{0,5})₂Si₅N₈:Eu in 950 g VE-Wasser suspendiert. Zu der Suspension werden unter Rühren bei 80 °C 600g einer wässrigen Lösung von 76,7 g AlCl₃ *6H₂O pro Kg Lösung enthält, in 2 ½ Stunden zudosiert. Dabei wird der pH-Wert durch Zudosierung von Natronlauge konstant auf 6,5 gehalten. Nach dem Ende der Zudosierung wird noch 1 Stunde bei 80°C nachgerührt, dann wird auf Raumtemperatur abgekühlt, der Leuchtstoff abfiltriert, mit Wasser gewaschen und getrocknet.

### Beschichtung des Leuchtstoffes aus den Beispielen 1 bis 4 mit funktionellen Gruppen:

### Ausführungsbeispiel 5a: Silane für Epoxypolymere (Hydrophile Variante, GE-Silane, Epoxy-Silan; für Epoxy-Harze geeignet)

100 g eines in den obigen Beispielen beschriebenen, mit SiO₂ und/oder Al₂O₃ beschichteten Leuchtstoffes werden in 1350 ml VE- Wasser unter intensivem Rühren suspendiert. Der pH-Wert der Suspension wird mit 5 wt % H₂SO₄ auf pH=6.5 eingestellt und die Suspension auf 75°C erhitzt. Anschließend werden 4,0 g eines 1:1-Gemisches von Silquest A-186^{®} [beta-(3,4-Epoxycyclohexyl)-ethyltrimethoxysilan] und Silquest A-1310^{®} [Gamma-isocyanatopropyltriethoxysilan] innerhalb von 60 min bei moderatem Rühren zur Suspension dazudosiert. Nach erfolgter Zugabe wird anschließend 15 min gerührt, um die Ankopplung der Silane an die Oberfläche zu vervollständigen. Der pH-Wert wird mittels 5 wt % H₂SO₄ auf 6.5 korrigiert.
Die Suspension wird anschließend abfiltriert und mit VE-Wasser salzfrei gewaschen. Die Trocknung erfolgt 20 h bei 130°C. Das so erhaltene Leuchtstoffpulver wird dann mittels 20 µm Sieb gesiebt.

### Ausführungsbeispiel 5b: Silane speziell für Silicon-Leuchtstoff-Ankopplung

100 g eines in den obigen Beispielen beschriebenen, mit SiO₂ und/oder Al₂O₃ beschichteten Leuchtstoffes werden in 1350 ml VE- Wasser unter intensivem Rühren suspendiert. Der pH-Wert der Suspension wird mit 5 wt % H₂SO₄ auf pH=6.5 eingestellt und die Suspension auf 75°C erhitzt. Anschließend werden 6,0 g eines 1:2-Gemisches von Silquest A-1110^{®} [gamma-aminopropytrimethoxysilan] und Silquest A-1524^{®} [Gamma-Harnstoffpropyltrimethoxysilan] innerhalb von 75 min bei moderatem Rühren zur Suspension dazudosiert. Nach erfolgter Zugabe wird anschließend 15 min gerührt, um die Ankopplung der Silane an die Oberfläche zu vervollständigen. Der pH-Wert wird mittels 5 wt % H₂SO₄ auf 6.5 korrigiert.
Die Suspension wird anschließend abfiltriert und mit VE-Wasser salzfrei gewaschen. Die Trocknung erfolgt 20 h bei 140°C. Das so erhaltene Leuchtstoffpulver wird dann mittels 20 µm Sieb gesiebt.

### Ausführungsbeispiel 5c: Vinylsilan für Silicon-Leuchtstoff-Ankopplung

100 g eines in den obigen Beispielen beschriebenen, mit SiO₂ und/oder Al₂O₃ beschichteten Leuchtstoffes werden in 1350 ml VE- Wasser unter intensivem Rühren suspendiert. Der pH-Wert der Suspension wird mit 5 wt % H₂SO₄ auf pH=6.8 eingestellt und die Suspension auf 75°C erhitzt. Anschließend werden 6,0 g eines 1:2-Gemisches von Silquest A-174^{®} [Gamma-Methacryloxypropyltrimethoxysilan] und Silquest A-151^{®} [Vinyltriethoxysilan] innerhalb von 90 min bei moderatem Rühren zur Suspension dazudosiert. Nach erfolgter Zugabe wird anschließend 15 min gerührt, um die Ankopplung der Silane an die Oberfläche zu vervollständigen. Der pH-Wert wird mittels 5 wt % H₂SO₄ auf 6.5 korrigiert. Die Suspension wird anschließend abfiltriert und mit VE-Wasser salzfrei gewaschen. Die Trocknung erfolgt 20 h bei 140°C. Das so erhaltene Leuchtstoffpulver wird dann mittels 20 µm Sieb gesiebt.

### Ausführungsbeispiel 6: Herstellung einer LED

Es werden die folgenden Mischungen in einem Speedmixer ® (Drehzahl 3000 UpM, Zeitdauer: 5 min, Raumtemperatur) hergestellt:
50 ml der beiden Harzkomponenten JCR 6122 a und b werden mit jeweils 8 Gew. % von dem nach Beispiel 3 a, b, oder c kompatibilisierten Leuchtstoffpulver und 1,2 % Kieselsäurepulver mit einem mittleren Durchmesser von 0,5 µm gemischt. Die beiden Harzmischungen werden vereinigt, gerührt und entgast. Danach werden 10 ml in das Vorratsgefäß eines Jetdispensers oder Schraubendosierventildispensers gefüllt. Unter das Dispensventil werden gebondete COB (Chip on Board) Roh-LED packages platziert. Nun werden mit dem Dispender glob tops aus der Harzmischung auf die Chips der Roh-LED packages getropft. Diese beschichteten LEDs werden im Trockenschrank bei 150°C über 1 Stunde temperiert. Dabei härtet das Harz aus.

### Beschreibung der Figuren

Im folgenden soll die Erfindung anhand mehrerer Ausführungsbeispiele näher erläutert werden. Es zeigen:
Fig. 1: Unbeschichtete Leuchtstoffe (1) in Harz (3) eingearbeitet über dem LED Chip (2). Die linke Graphik stellt den Zustand direkt nach dem Aufbringen des Leuchtstoff-Harzgemisches auf den Chip dar. Nach dem Aushärten des Harzes (4) ist der Zustand der Leuchtstoffharzmischung wie folgt (rechte Skizze): die größeren Leuchtstoffpartikel zeigen eine starke Tendenz zur Sedimentation. Dadurch verteilen sich die Partikel inhomogen. Diese Verteilung wird nach der Harzverfestigung "eingefroren".
Fig.2: Erfindungsgemäß beschichtete Leuchtstoffe (1) in Harz (3) eingearbeitet über dem LED Chip (2). Die linke Abbildung zeigt die homogene Verteilung der einheitlichen Leuchtstoffpulver. Diese Homogenität wird durch die erfindungsgemäße Kompatibilisierung der Leuchtstoffoberfläche mit den Harzeigenschaften ermöglicht. Während der Aushärtung kommt es nicht zu einer Störung der Verteilung, weil die Leuchtstoffe erfindungsgemäß mit dem Harz vernetzt oder chemisch verbunden sind. Schlussendlich ist die Leuchtstoffschicht über der LED einheitlich (siehe rechte Abbildung).

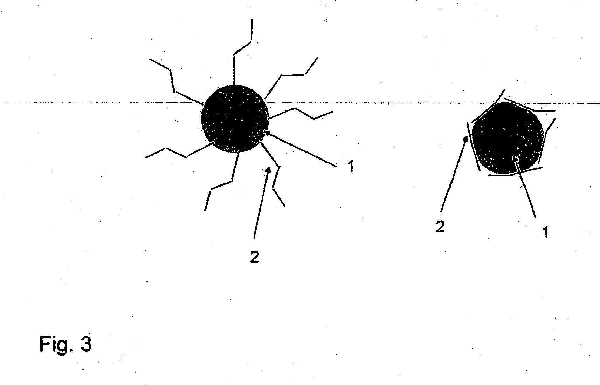

Fig. 3: zeigt Silicon- bzw. Silan beschichtete Leuchtstoffpartikel (1) mit zwei unterschiedlichen Strukturen bzgl. der Polymerketten (2). Die oberflächengebundenen Polymerketten verbessern einerseits die Dispergierbarkeit der Leuchtstoffpartikel im Harz. Andererseits können die Polymerketten als "Spacer" wirken und somit die Agglomeration von Leuchtstoffpartikeln verhindern. Des Weiteren wird eine Anbindung der kompatibilisierten Leuchtstoffpartikel an das Harz (Vernetzung oder Reaktion mit Bestandteilen des Harzes) erzielt.

## Patentansprüche

1. Oberflächenmodifizierte Leuchtstoffpartikel auf der Basis von lumineszierenden Teilchen, die mindestens eine lumineszierende Verbindung ausgewählt aus der Gruppe der (Y, Gd, Lu, Sc, Sm, Tb)₃ (Al, Ga)sO₁₂:Ce (mit oder ohne Pr), YSiO₂N:Ce, Y₂Si₃O₃N₄:Ce, Gd₂Si₃O₃N₄:Ce, BaMgAl₁₀O₁₇:Eu (mit oder ohne Mn), Sr₄Al₁₄O25:Eu, (Ca,Sr,Ba)Si₂N₂O₂:Eu, SrSiAl₂O₃N₂:Eu, (Ca,Sr,Ba)₂Si₅N₈:Eu, (Ca,Sr,Ba)SiN₂:Eu, CaAlSiN₃:Eu, Molybdate, Wolframate, Vanadate, jeweils einzeln oder Gemischen derselben mit einem oder mehreren Aktivatorionen wie Ce, Eu, Mn, Cr, Tb und/oder Bi enthalten, wobei (Ca,Sr,Ba)₂SiO₄ und andere Silikate mit einem oder mehreren Aktivatorionen wie Eu, Ce und Mn und/oder Codotanten basierend auf Fe, Cu und/oder Zn als lumineszierende Verbindungen ausgenommen sind,
**dadurch gekennzeichnet, dass** auf den lumineszierenden Teilchen mindestens eine anorganische Schicht, enthaltend Oxide oder Hydroxide von Si, Al, Zr, Zn, Ti und/oder Mischungen hieraus, sowie eine organische Beschichtung aus Organosilanen oder Polyorganosiloxanen (Silicone) und/oder Mischungen hieraus, aufgebracht ist.

2. Oberflächenmodifizierte Leuchtstoffpartikel nach Anspruch 1, **dadurch gekennzeichnet, dass** die Partikelgröße der Leuchtstoffpartikel zwischen 1 und 40 µm liegt.

3. Oberflächemodifizierte Leuchtstoffpartikel nach Anspruch 1 und/oder 2, **dadurch gekennzeichnet, dass** die anorganische Beschichtung und die organische Beschichtung weitgehend transparent sind.

4. Verfahren zur Herstellung eines oberflächenmodifizierten Leuchtstoffpartikels nach Anspruch 1, **gekennzeichnet durch** die Schritte:
a) Nasschemisches Herstellen eines Leuchtstoffpartikels gemäß Anspruch 1 **durch** Mischen von mindestens zwei Edukten und mindestens einem Dotierstoff aus den entsprechenden organischen und/oder anorganischen Metall-, Halbmetall-, Übergangsmetall- und/oder Seltenerd-Salzen mittels Sol-Gel-Verfahren und/oder Präzipitationsverfahren und thermische Behandlung bei einer Temperatur T > 150 °C,
b) der Leuchtstoffpartikel wird in einem nasschemischen oder Aufdampfprozess mit einer anorganischen Schicht enthaltend Oxide oder Hydroxide von Al, Zr, Zn, Ti und/oder Mischungen hieraus, beschichtet,
c) Aufbringung einer organischen Beschichtung aus Organosilanen oder Polyorganosiloxanen (Silicone) und/oder Mischungen hieraus.

5. Verfahren nach Anspruch 4, **dadurch gekennzeichnet, dass** das anorganische Oxid sowie die organische Beschichtung weitgehend transparent sind.

6. Verfahren nach Anspruch 4 und/oder 5, **dadurch gekennzeichnet, dass** die Beschichtung mit mindestens einem anorganischen Oxid mittels Zugabe wässriger oder nichtwässriger Lösungen von nichtflüchtigen Salzen und/oder metallorganischen Verbindungen durchgeführt wird.

7. Verfahren nach einem oder mehreren der Ansprüche 4 bis 6, **dadurch gekennzeichnet, dass** die Edukte und der Dotierstoff anorganische und/oder organische Stoffe wie Nitrate, Carbonate, Hydrogencarbonate, Phosphate, Carboxylate, Alkoholate, Acetate, Oxalate, Halogenide, Sulfate, metallorganische Verbindungen, Hydroxide und/oder Oxide der Metalle, Halbmetalle, Übergangsmetalle und /oder Seltenerden sind, welche in anorganischen und/oder organischen Flüssigkeiten gelöst und/oder suspendiert sind.

8. Verfahren nach Anspruch 4, **dadurch gekennzeichnet, dass** Verfahrensschritt b), nämlich die Beschichtung mit einer anorganischen Schicht, entfällt.

9. Beleuchtungseinheit mit mindestens einer Primärlichtquelle, deren Emissionsmaximum im Bereich 250 nm bis 530 nm liegt, vorzugsweise zwischen 380 nm und 500 nm, wobei diese Strahlung teilweise oder vollständig in längerwellige Strahlung konvertiert wird durch oberflächenmodifizierte Leuchtstoffpartikel nach einem oder mehreren der Ansprüche 1 bis 3.

10. Beleuchtungseinheit nach Anspruch 9, **dadurch gekennzeichnet, dass** es sich bei der Lichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 handelt.

11. Beleuchtungseinheit nach Anspruch 9, **dadurch gekennzeichnet, dass** der Leuchtstoff direkt auf der primären Lichtquelle und/oder von dieser entfernt angeordnet ist.

12. Beleuchtungseinheit nach Anspruch 9, **dadurch gekennzeichnet, dass** die optische Ankopplung zwischen dem Leuchtstoff und der primären Lichtquelle durch eine lichtleitende Anordnung realisiert ist.

13. Beleuchtungseinheit nach Anspruch 9, **dadurch gekennzeichnet, dass** es sich bei der Lichtquelle um eine auf einer organischen lichtemittierenden Schicht basierendes Material handelt.

14. Beleuchtungseinheit nach Anspruch 9, **dadurch gekennzeichnet, dass** es sich bei der Lichtquelle um eine Quelle handelt, die Elektrolumineszenz und/oder Photolumineszenz zeigt.

15. Verwendung von mindestens einem oberflächenmodifizierten Leuchtstoffpartikel nach Anspruch 1 als Konversionsleuchtstoff zur Konversion der Primärstrahlung in einen bestimmten Farbpunkt nach dem color-on-demand-Konzept.

16. Verwendung von mindestens einem oberflächenmodifizierten Leuchtstoffpartikel nach Anspruch 1 zur Konversion der blauen oder im nahen UV-liegenden Emission in sichtbare weiße Strahlung.

## Claims

1. Surface-modified phosphor particles based on luminescent particles which comprise at least one luminescent compound selected from the group of (Y,Gd,Lu,Sc,Sm,Tb)₃(Al,Ga)₅O₁₂:Ce (with or without Pr), YSiO₂N:Ce, Y₂Si₃O₃N₄:Ce, Gd₂Si₃O₃N₄:Ce, BaMgAl₁₀O₁₇:Eu (with or without Mn), Sr₄Al₁₄O₂₅:Eu, (Ca,Sr,Ba)Si₂N₂O₂:Eu, SrSiAl₂O₃N₂:Eu, (Ca,Sr,Ba)₂Si₅N₈:Eu, (Ca,Sr,Ba)SiN₂:Eu, CaAlSiN₃:Eu, molybdates, tungstates, vanadates, in each case individually or mixtures thereof with one or more activator ions, such as Ce, Eu, Mn, Cr, Tb and/or Bi, where (Ca,Sr,Ba)₂SiO₄ and other silicates having one or more activator ions, such as Eu, Ce and Mn, and/or codopants based on Fe, Cu and/or Zn are excluded as luminescent compounds,
**characterised in that** at least one inorganic layer comprising oxides or hydroxides of Si, Al, Zr, Zn, Ti and/or mixtures thereof and an organic coating comprising organosilanes or polyorganosiloxanes (silicones) and/or mixtures thereof is applied to the luminescent particles.

2. Surface-modified phosphor particles according to Claim 1, **characterised in that** the particle size of the phosphor particles is between 1 and 40 µm.

3. Surface-modified phosphor particles according to Claim 1 and/or 2, **characterised in that** the inorganic coating and the organic coating are substantially transparent.

4. Process for the production of a surface-modified phosphor particle according to Claim 1, **characterised by** the steps:
a) wet-chemical production of a phosphor particle according to Claim 1 by mixing at least two starting materials and at least one dopant comprising the corresponding organic and/or inorganic metal, semimetal, transition-metal and/or rare-earth metal salts by means of sol-gel processes and/or precipitation processes and thermal treatment at a temperature T > 150°C,
b) the phosphor particle is coated with an inorganic layer comprising oxides or hydroxides of Al, Zr, Zn, Ti and/or mixtures thereof in a wet-chemical or vapour-deposition process,
c) application of an organic coating comprising organosilanes or polyorganosiloxanes (silicones) and/or mixtures thereof.

5. Process according to Claim 4, **characterised in that** the inorganic oxide and the organic coating are substantially transparent.

6. Process according to Claim 4 and/or 5, **characterised in that** the coating is carried out with at least one inorganic oxide by addition of aqueous or non-aqueous solutions of non-volatile salts and/or organometallic compounds.

7. Process according to one or more of Claims 4 to 6, **characterised in that** the starting materials and the dopant are inorganic and/or organic substances, such as nitrates, carbonates, hydrogencarbonates, phosphates, carboxylates, alcoholates, acetates, oxalates, halides, sulfates, organometallic compounds, hydroxides and/or oxides of the metals, semimetals, transition metals and/or rare-earth metals, which are dissolved and/or suspended in inorganic and/or organic liquids.

8. Process according to Claim 4, **characterised in that** process step b), namely the coating with an inorganic layer, is omitted.

9. Lighting unit having at least one primary light source whose emission maximum is in the range 250 nm to 530 nm, preferably between 380 nm and 500 nm, where some or all of this radiation is converted into longer-wavelength radiation by surface-modified phosphor particles according to one or more of Claims 1 to 3.

10. Lighting unit according to Claim 9, **characterised in that** the light source is a luminescent indium aluminium gallium nitride, in particular of the formula InᵢGaⱼAlₖN, where 0 ≤ i, 0 ≤ j, 0 ≤ k, and l + j + k = 1.

11. Lighting unit according to Claim 9, **characterised in that** the phosphor is arranged directly on the primary light source and/or remote therefrom.

12. Lighting unit according to Claim 9, **characterised in that** the optical coupling between the phosphor and the primary light source is achieved by means of a light-conducting arrangement.

13. Lighting unit according to Claim 9, **characterised in that** the light source is a material based on an organic light-emitting layer.

14. Lighting unit according to Claim 9, **characterised in that** the light source is a source which exhibits electroluminescence and/or photoluminescence.

15. Use of at least one surface-modified phosphor particle according to Claim 1 as conversion phosphor for conversion of primary radiation into a certain colour point in accordance with the colour-on-demand concept.

16. Use of at least one surface-modified phosphor particle according to Claim 1 for conversion of blue or near-UV emission into visible white radiation.

## Revendications

1. Particules de phosphore modifiées en surface basées sur des particules luminescentes qui comprennent au moins un composé luminescent choisi parmi le groupe constitué par (Y,Gd,Lu,Sc,Sm,Tb)₃(Al,Ga)₅O₁₂:Ce (avec ou sans Pr), YSiO₂N:Ce, Y₂Si₃O₃N₄:Ce, Gd₂Si₃O₃N₄:Ce, BaMgAl₁₀O₁₇:Eu (avec ou sans Mn), Sr₄Al₁₄O₂₅:Eu, (Ca,Sr,Ba)Si₂N₂O₂:Eu, SrSiAl₂O₃N₂:Eu, (Ca,Sr,Ba)₂Si₅N₈:Eu, (Ca,Sr,Ba)SiN₂:Eu, CaAlSiN₃:Eu, les molybdates, les tungstates, les vanadates, dans chaque cas de manière individuelle ou des mélanges afférents avec un ou plusieurs ion(s) activateur(s), tels que Ce, Eu, Mn, Cr, Tb et/ou Bi, où (Ca,Sr,Ba)₂SiO₄ et d'autres silicates comportant un ou plusieurs ion(s) activateur(s), tels que Eu, Ce et Mn, et/ou des co-dopants basés sur Fe, Cu et/ou Zn sont exclus en tant que composés luminescents, **caractérisées en ce qu'**au moins une couche inorganique comprenant des oxydes ou des hydroxydes de Si, Al, Zr, Zn, Ti et/ou des mélanges afférents et un revêtement organique comprenant des organosilanes ou des polyorganosiloxanes (des silicones) et/ou des mélanges afférents est appliquées sur les particules luminescentes.

2. Particules de phosphore modifiées en surface selon la revendication 1, **caractérisées en ce que** la dimension de particule des particules de phosphore est entre 1 et 40 µm.

3. Particules de phosphore modifiées en surface selon les revendications 1 et/ou 2, **caractérisées en ce que** le revêtement inorganique et le revêtement organique sont sensiblement transparents.

4. Procédé pour la fabrication d'une particule de phosphore modifiée en surface selon la revendication 1, **caractérisé par** les étapes qui suivent :
a) fabrication par voie chimique humide d'une particule de phosphore selon la revendication 1 en mélangeant au moins deux matériaux de départ et au moins un dopant comprenant les sels de métaux, de semi-métaux, de métaux de transition et/ou de métaux des terres rares organiques et/ou inorganiques correspondants au moyen de procédés sol-gel et/ou de procédés par précipitation et d'un traitement thermique à une température T > 150°C,
b) la particule de phosphore est revêtue d'une couche inorganique comprenant des oxydes ou des hydroxydes de Al, Zr, Zn, Ti et/ou des mélanges afférents lors d'un procédé par voie chimique humide ou de dépôt en phase vapeur,
c) application d'un revêtement organique comprenant des organosilanes ou des polyorganosiloxanes (des silicones) et/ou des mélanges afférents.

5. Procédé selon la revendication 4, **caractérisé en ce que** l'oxyde inorganique et le revêtement organique sont sensiblement transparents.

6. Procédé selon la revendication 4 et/ou 5, **caractérisé en ce que** le revêtement est mis en oeuvre avec au moins un oxyde inorganique par ajout de solutions aqueuses ou non aqueuses de sels non volatiles et/ou de composés organométalliques.

7. Procédé selon une ou plusieurs des revendications 4 à 6, **caractérisé en ce que** les matériaux de départ et le dopant sont des substances inorganiques et/ou organiques, telles que des nitrates, des carbonates, des hydrogènecarbonates, des phosphates, des carboxylates, des alcoolates, des acétates, des oxalates, des halogénures, des sulfates, des composés organométalliques, des hydroxydes et/ou des oxydes des métaux, des semi-métaux, des métaux de transition et/ou des métaux des terres rares, lesquels sont dissous et/ou suspendus dans des liquides inorganiques et/ou organiques.

8. Procédé selon la revendication 4, **caractérisé en ce que** l'étape de procédé b), à savoir le revêtement avec une couche inorganique, est omise.

9. Unité d'éclairage comportant au moins une source de lumière primaire dont le maximum d'émission est dans la plage de 250 nm à 530 nm, de façon préférable entre 380 nm et 500 nm, où une certaine part ou la totalité de ce rayonnement est convertie selon un rayonnement de longueur d'onde plus longue par des particules de phosphore modifiées en surface selon une ou plusieurs des revendications 1 à 3.

10. Unité d'éclairage selon la revendication 9, **caractérisée en ce que** la source de lumière est un nitrure d'indium aluminium gallium luminescent, en particulier de la formule InᵢGaⱼAlₖN, où 0 ≤ i, 0 ≤ j, 0 ≤ k, et l + j + k = 1.

11. Unité d'éclairage selon la revendication 9, **caractérisée en ce que** le phosphore est agencé directement sur la source de lumière primaire et/ou à distance de celle-ci.

12. Unité d'éclairage selon la revendication 9, **caractérisée en ce que** le couplage optique entre le phosphore et la source de lumière primaire est réalisé au moyen d'un agencement de conduction de lumière.

13. Unité d'éclairage selon la revendication 9, **caractérisée en ce que** la source de lumière est un matériau basé sur une couche d'émission de lumière organique.

14. Unité d'éclairage selon la revendication 9, **caractérisée en ce que** la source de lumière est une source qui présente une électroluminescence et/ou une photoluminescence.

15. Utilisation d'au moins une particule de phosphore modifiée en surface selon la revendication 1 en tant que phosphore de conversion pour la conversion du rayonnement primaire selon un certain point de couleur conformément au concept de couleur à la demande.

16. Utilisation d'au moins une particule de phosphore modifiée en surface selon la revendication 1 pour la conversion d'une émission de bleu ou d'UV proches selon un rayonnement blanc visible.
